Europäisches Patentamt

European Patent Office

Office européen des brevets

(19)

(11) EP 1 388 946 A1

(12) EUROPEAN PATENT APPLICATION

(43) Date of publication:
11.02.2004 Bulletin 2004/07

(51) Int Cl.7: H03M 13/00, G11B 20/18

(21) Application number: 03291868.2

(22) Date of filing: 28.07.2003

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 10.08.2002 EP 02090289

(71) Applicant: Thomson Licensing S.A.
92100 Boulogne-Billancourt (FR)

(72) Inventors:
• Kravtchenko, Alexander
78056 Villingen-Schwenningen (DE)

• Kubutz, Marten
78052 Villingen-Schwenningen (DE)
• Ramadoss, Vijaya
Westfiled, IN 46074 (US)
• Singh, Amit
Indianapolis, IN 46240 (US)

(74) Representative:
Hartnack, Wolfgang, Dipl.-Ing. et al
Deutsche Thomson-Brandt GmbH
European Patent Operations
Karl-Wiechert-Allee 74
30625 Hannover (DE)

(54) **Cross interleave reed-solomon code correction**

(57)    The invention relates to a method for cross interleave Reed-Solomon code correction comprising the steps of:

-    inputting of a first C1 codeword into C1 decoder means from a first memory means,
-    outputting of a second C1 codeword into a second memory means from the C1 decoder means,
-    de-interleaving the second C1 codeword to produce a first C2 codeword in the second memory means.

Fig.2

**Description**

This invention relates generally to a method and apparatus for performing error correction on digital data using a Reed-Solomon code, and more particularly, to a method and apparatus for cross interleave Reed-Solomon code correction.

Background

One error correction code that is typically used in compact audio discs is the so-called CIRC correction code. CIRC is an acronym for Cross Interleave Reed-Solomon Code. In the case of the CIRC correction code, the encoding process of the (28, 24) Reed-Solomon code (C2 code) is performed for twenty-four data symbols, with each symbol consisting of 8 bits. In such typical audio applications each audio sample is 16 bits, which is formed of two symbols of 8 bits each. Thus, each 8-bit symbol is either the upper or lower side of an audio sample of one of the two channels of stereophonic audio data.

These data symbols are in a first state of arrangement and, next, the data is rearranged from the first arrangement state to a second state of arrangement by an interleaving operation. The encoding process of the (32, 28) Reed-Solomon code (C1 code) is then executed for the twenty-eight symbols that are now in the second arrangement state. When decoding the CIRC correction code, the C1 decoding is performed first, then the de-interleave is performed and, thereafter, the C2 decoding is performed.

Various methods of decoding the CIRC correction code are already known, and examples of such methods are disclosed in US-A-4 546 474, US-A-4 476 562 and US-A-4 497 058, for example. On the other hand, various methods of decoding the Reed-Solomon code are also known, and examples of such methods are disclosed in US-A-4 476 562.

According to the conventional decoding methods of the CIRC correction code, error processing up to and including double-error correction is executed in the C1 decoding in the first stage, and double-error correction is executed in the C2 decoding at the next stage by referring to pointer information that is derived from the C1 decoding.

One method of decoding the error correction code that has been proposed is the so-called erasure correction method, in which the location of the error symbol is indicated by pointer information and the necessary correction is performed on this error symbol. In the case of the above-mentioned C1 and C2 codes, detection and correction up to and including double errors (two symbols) can be respectively performed. However, if the error location is already known, then error correction up to and including quadruple errors (four symbols) can be performed.

Therefore, in order to raise the error correction capability, it has been preferred to perform the erasure correction method of decoding the error. Furthermore, the erasure correction method has been found to be particularly effective in correcting burst errors. On the other hand, in order to perform the erasure correction operation properly, the error locations must be preliminarily known from the pointer information and, moreover, the reliability of that pointer information must be relatively high.

According to the conventional coding method of the CIRC correction code, error correction up to and including double errors is executed in the C1 decoder. In such case, because there is a fear of the occurrence of triple errors, which of course could not be corrected, the C1 pointer is sent to the C2 decoder in the next stage, so that error correction is executed in the C2 decoder using the C1 pointer.

More specifically, in the case of the conventional CIRC correction code, the series of the C1 code (C1 series) is formed by 32 symbols that are alternately included in two adjacent frames (one frame: 32 symbols). The series of the C2 code (C2 series) is formed by 28 symbols that are included in predetermined ones of 108 consecutive frames. Because the interleave length of the C1 series is shorter than that of the C2 series, when a fast-forward reproduction operation, such as queuing or review, is performed, a problem occurs in that some frames are dropped and the continuity of the frames is lost.

That is, the C1 pointer is used to indicate the presence of errors in the one frame before and after the point of the discontinuity, however, the C1 pointer only indicates the absence of the errors in the other frame. On the other hand, the interleave length of the C2 series has 108 frames, and these 108 frames will include the point of discontinuity. Thus, this is also not the correct C2 series. Upon performing the erasure correction for the incorrect C2 series by use of the foregoing C1 pointer, the error correction will be incorrect.

To solve this problem of incomplete or incorrect error correction when performing error correction of the CIRC correction code, wherein the maximum error correcting capability is obtained by the erasure correction method, there has been proposed an error correction method wherein the C1 decoding and C2 decoding are executed twice in a specific order (such double-execution of C1 decoding and C2 decoding is disclosed in US-A-4 637 021). That order might be, for example, C1 decoding, followed by C2 decoding, followed by C1 decoding, and followed by C2 decoding. In the first C2 decoding, erasure correction is performed using the C1 pointer obtained by the C1 decoding at the front stage and the erroneous correction that may occur at this erasure correction is prevented by the second C1 decoding and the C2 decoding, which are similar to the conventional method of decoding the CIRC correction code.

EP-A-0 278 383 shows an error correction method using Reed-Solomon code. When the error correction is performed by using the result of the multiplication of a syndrome and an error location, another syndrome is added to thereby form a new syndrome. By repetitively executing this procedure, the error vector is obtained by a number of arithmetic operations, thereby performing error correction by the so-called erasure correction technique. Then, by calculating another error vector using the first calculated error vector, the number of arithmetic operation times can be reduced.

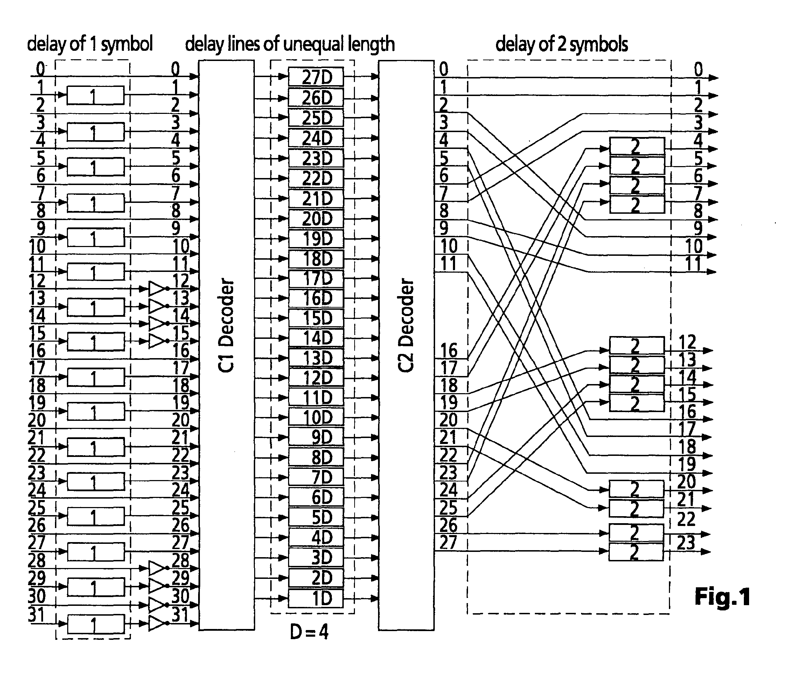

Figure 1 is a block diagram to illustrate conventional cross interleave Reed-Solomon code (CIRC) decoding of the Reed-Solomon (RS) codes. The main tasks of the CIRC decoder are to perform:

1. Delaying incoming data by one-symbol;
2. Decoding the C1 code (32, 28) and correcting erroneous symbols;
3. De-interleaving;
4. Decoding the C2 code (28, 24) and correction of erroneous symbols;
5. Delay of two symbols.

32 symbols of incoming data form one frame and are supplied to the time delay circuit (delay of one-symbol), in which only the even numbered symbols are delayed by an amount to one frame. 32 symbols output from the time delay circuit are supplied to a C1 decoder, in which the actual decoding of the (32, 28) Reed-Solomon code (C1 code word) is executed. The error correction of up to two errors symbol in a C1 code word is performed in the C1 decoder. When three or more errors are detected in a C1 decoder, the C1 pointer (erasure flag) is set for all symbols in a C1 code word. The data and erasure flags are further processed in the de-interleave circuit (delay lines of unequal length). The output of the de-interleave circuit is supplied to a C2 decoder. In the de-interleave circuit the erasure flag of each symbol generated from a C1 decoder is de-interleaved in a manner similar to the de-interleave of the data. The erasure correction of up to four errors is executed in a C2 decoder by use of the C1 erasure flags.

If correction of up to four error symbols is possible by a C2 decoder then a C1 erasure flags are cleared. If it is not possible then either the C1 erasure flags in a C2 code word are copied or erasure flags to all symbol of a C2 code word are set. The last stage in the CIRC decoding is a two-symbol delay. It is executed by a two-symbol delay circuit. Double usage of the CIRC correction codes leads to an increase of the correcting capability of the error correction system.

Invention

However, it is a common disadvantage of such conventional CIRC decoders of the type as shown in Fig. 1 that they are incapable of double processing of blocks of the CIRC codes.

It is therefore an object of the present invention to provide for an improved method for CIRC correction and an improved computer program and Reed-Solomon decoder for CIRC correction.

The present invention provides for an improved method for CIRC correction in accordance with claim 1. Further the present invention provides for an improved computer program and Reed-Solomon decoder in accordance with the further independent claims.

Preferred embodiments of the invention are given in the dependent claims.

The present invention enables single pass and double pass operation of the CIRC decoder.

One-symbol delay operation, two-symbol delay operation and the double or single decoding of the CIRC correction code are achieved by using four separate memories, and by the special controlling and addressing of each memory.

The present invention is particularly advantageous in that it enables double processing of blocks of the CIRC codes.

Drawings

Exemplary embodiments of the invention are described with reference to the accompanying drawings, which show in:

Fig. 1 block diagram of a prior art CIRC decoder;

Fig. 2 block diagram illustrating the first pass of a CIRC decoder in accordance with an embodiment of the invention;

Fig. 3 block diagram illustrating the second pass of the decoder of Fig. 2;

Fig. 4 block diagram illustrating an alternative embodiment of a CIRC decoder;

Fig. 5 flow chart for the operation of the CIRC decoder for double and single processing of the CIRC correction code;

Fig. 6      scheme illustrating the data flow in the M1 memory;

Fig. 7      block diagram illustrating the calculation of addresses in the M1 memory;

Fig. 8      illustration of the operation of the memory M2,a;

Fig. 9      further illustration of the operation of the memory M2, a;

Fig. 10     block diagram illustrating the calculation of addresses in the M2 memory;

Fig. 11     characteristic lines illustrating the results of correction of different burst errors.

<u>Exemplary embodiments</u>

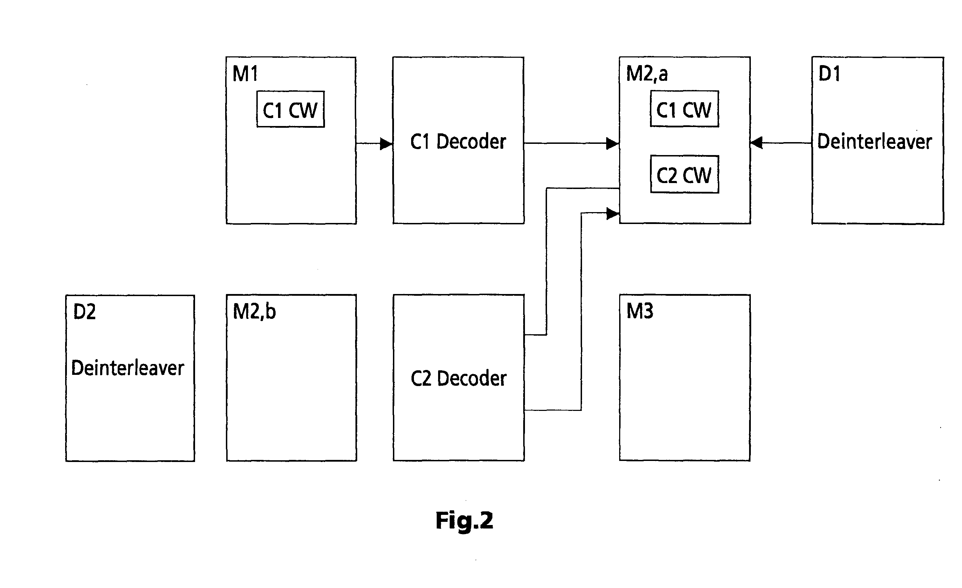

Fig. 2 shows a block diagram of a CIRC decoder. The decoder has a memory M1 for storage of C1 code words (CW). Further there is a C1 decoder, a memory M2,a with associated de-interleaver D1, a memory M2,b within an associated de-interleaver D2, a C2 decoder and a memory M3.

At the beginning of the first pass the C1 CW is stored in the memory M1. From there the C1 CW is inputted into the C1 decoder. The C1 decoder outputs another C1 CW into M2,a. The C1 CW which is outputted from the C1 decoder is a copy of the C1 CW of memory M1, if the C1 CW of memory M1 is not correctable.

In this instance the erasure flags are set for all the symbols within the C1 CW. If the C1 CW of memory M1 is correctable the C1 CW which is outputted from the C1 decoder is the corrected C1 CW of memory M1.

A de-interleaving operation is performed by means of de-interleaver D1. As a result a C2 CW is stored in memory M2,a. The C2 CW of memory M2,a is inputted into the C2 decoder. The C2 decoder writes a C2 CW back to memory M2,a. This C2 CW is either a copy of the original C2 CW in case the original C2 CW is not correctable, or it is the corrected C2 CW. When the C2 CW is not correctable again the erasure flags are set.

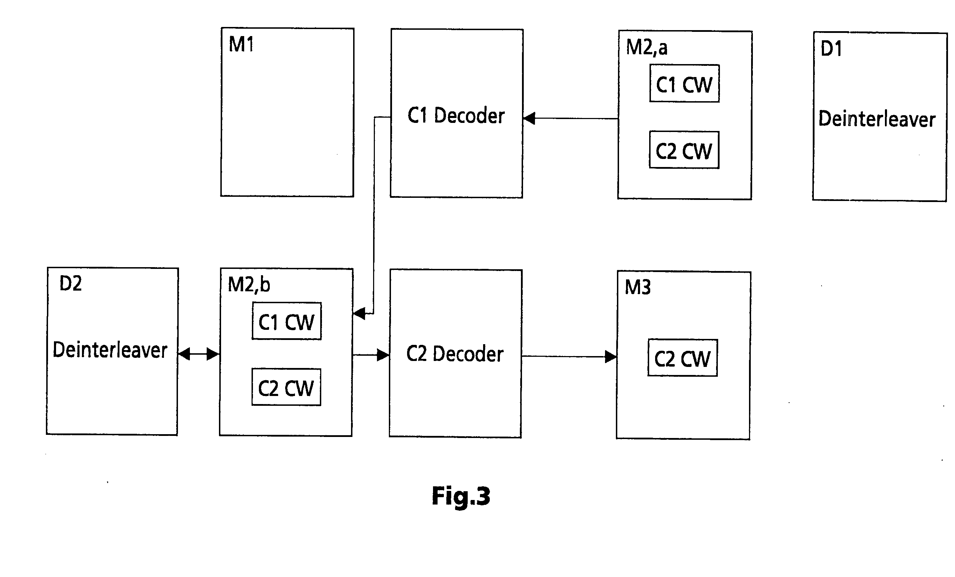

Figure 3 is illustrative of the second pass. The C1 CW of M2,a is inputted into the C1 decoder. The C1 decoder outputs a C1 CW into memory M2,b. The C1 CW of memory M2,b is either a copy of the C1 CW of memory M2,a in case the C1 CW of memory M2,a is not correctable, or it is the corrected C1 CW of the memory M2,a. In case the C1 CW of memory M2,a is not correctable the erasure flags are set in the codeword C1 CW which is outputted from C1 decoder and stored in memory M2,b.

The de-interleaver D2 is started. As a result a codeword C2 CW is provided in memory M2,b. This is inputted into the C2 decoder. The C2 decoder outputs a codeword C2 CW into memory M3. The C2 CW which is outputted by the C2 decoder is either a copy of the C2 CW of memory M2,b in case the C2 CW of memory M2,b is not correctable, or it is the corrected C2 CW of memory M2,b. In case the C2 CW of memory M2,b is not correctable the erasure flags are set.

In the following a more detailed embodiment will be described:

*System Components*

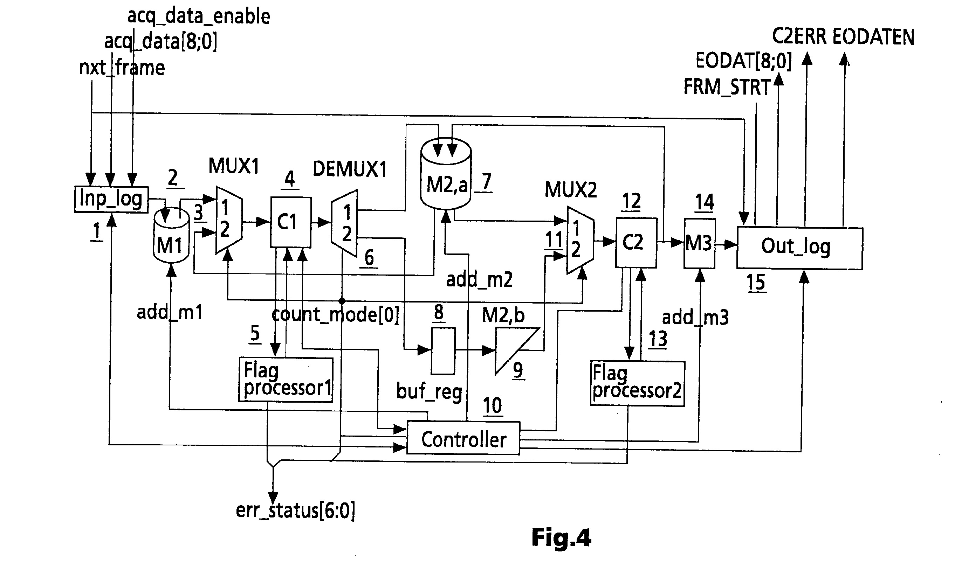

Figure 4 illustrates the block diagram of the CIRC decoder showing the major components of the CIRC decoder (double and single pass of the CIRC decoder is implemented in this architecture).

The data stream from the acquisition part is stored into an input logic 1. The input logic is able to store 32 symbols. If sufficient data is available in the buffer of the input logic then a frame is stored into the M1 memory. M1 memory is used for one-symbol delay task of the CIRC decoder. The MUX1 multiplexer 3 is used to multiplex the data either from the M1 memory to the C1 decoder or from the M2,a memory to the C1 decoder depends on the pass of the CIRC decoder.

The block 4 is the conventional RS decoder. In this block a so-called erasure correction method of RS code is implemented. RS decoder 4 is able to correct four erasures or two errors or any combinations of errors and erasures under the condition: $2*t+E<d$, where t-number of errors in a code word, E-number of erasures, d-Hamming distance of the RS code ($d = 5$ for compact audio disc application).

A flag processor block No.1 (block 5) generates the error status of the C1 decoder and defines an output erasure flag. A demultiplexer (DEMUX1) 6 is used for de-multiplexing the C1 decoder output either to the M2,a memory or to a register (buf_reg) 8. The output of demultiplexer 6 depends on the pass of the CIRC decoder.

An M2,a memory 7 is used for the de-interleaving and for assembling C1 code words in C2 code words during the first pass of the CIRC decoder. Register 8 is used to memorise the corrected C1 code word. An M2,b memory 9 is used for the de-interleaving and for assembling C1 code words in C2 code words during the second pass of the CIRC decoder. A controller 10 of the CIRC decoder performs the memories management during the following tasks:

a) One-symbol delay task;

b) C1 decoder task;

c) De-interleave and C2 decoder task;

d) Two-symbol delay task.

A multiplexer 11 (MUX2) is used to multiplex the data either from the M2,a memory to the C2 decoder or from the M2,b memory to the C2 decoder, depending on the pass of the CIRC decoder. Block 12 is a conventional RS decoder. This decoder has the same performance like the RS decoder 4.

The flag processor block No.2 (block 13) generates the error status of the C2 decoder and defines an output erasure flag. An M3 memory 14 is used for the two-symbol delay task of the CIRC decoder. An output logic 15 is used to store 24 symbols from the M3 memory.

*Controlling the data in the CIRC decoder*

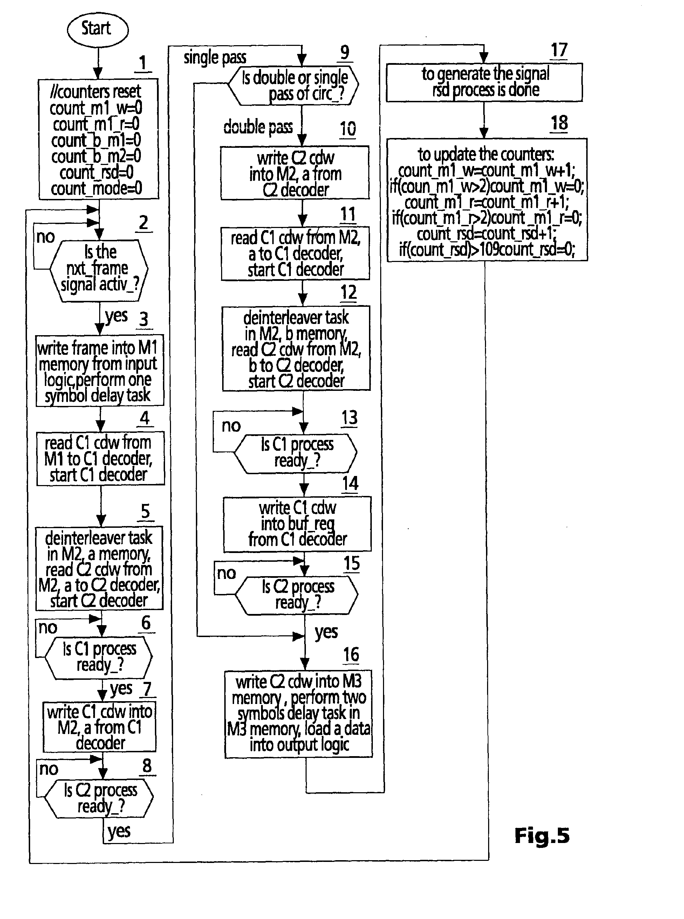

The operation of the CIRC decoder for double and single processing of the CIRC correction code is depicted by the flow diagram of Fig. 5.

If the nxt_frame signal is active (step 2) then a frame is loaded from input logic into the corresponding bank of the M1 memory and the one-symbol delay task is executed (step 3).

During step 4 the data are transferred from the M1 memory (see Fig. 4) through the MUX1 multiplexer to the C1 decoder. At the same time the syndrome is calculated. The decoding process C1 is started after transferring 32 symbols. The de-interleaver task (step 5) is performed in the M2,a memory. 28 symbols of the C2 code word are transferred from the M2,a memory through MUX2 multiplexer to the C2 decoder. At the same time the syndrome is calculated. The decoding process C2 is started after transferring 28 symbols.

After start of the C1, C2 processes, the controller waits for an even - C1 process ready (step 6). If the C1 process is ready a C1 code word from a C1 decoder is written into the M2,a memory (step 7). Then the controller is waiting for an even - C2 process ready (step 7).

The next step in the data flow depends on single or double pass operation of the CIRC decoder (step 9). If the CIRC decoder performs single pass and the C2 process is ready then a corrected C2 code word from the C2 decoder is written into the M3 memory. Then the two-symbol delay task is performed into the M3 memory. Afterwards a corresponding data item is loaded into output logic (step 16).

If the CIRC decoder performs double pass and the C2 process is ready then a corrected C2 code word from the C2 decoder is written into the M2,a memory (step 10) and the second pass of the CIRC decoder is to be started.

The C1 code word is transferred from the M2,a memory through MUX1 multiplexer to the C1 decoder. At the same time the syndrome is calculated. The decoding process C1 is started after transferring 32 symbols (step 11).

The de-interleaver task (step 12) is performed in the M2,b memory. 28 symbols of the C2 code word are transferred from the M2,b memory through the MUX2 multiplexer to the C2 decoder. At the same time the syndrome is calculated. The decoding process C2 is started after transferring 28 symbols.

After start of the C1, C2 processes, the controller waits for an even - C1 process ready (step 13).

If the C1 process is ready then the corrected C1 code word from a C1 decoder is written into buf_reg (step 14).

If the C2 process ready then the corrected C2 code word from a C2 decoder is written into the M3 memory (step 16). Then the two-symbol delay task is performed into the M3 memory. Thereafter a corresponding data item is loaded into output logic (step 16).

The counters are updated during the step 18. Following step 18, the ECC block is ready to process a new frame from the input logic.

*Addressing the data in the CIRC decoder*

Addressing and determining locations in different memories and controlling the transferred data bytes at read and write operations, during the one-symbol delay, de-interleaving and two-symbol delay operations, are performed using controller 10.

*One-symbol delay task*

The M1 memory is used for the one-symbol delay task of the CIRC decoder and comprises three banks with the addresses 0, 1, and 2. Each bank consists of 32 symbols. Each symbol contains 9 bytes. The MS bit is "erasure flag", (7:0) bits are the data. An erasure bit indicates that a symbol is corrupted. If sufficient data is available in the buffer of the input logic then a frame is stored into the corresponding bank of the M1 memory and the one-symbol delay operation is executed.

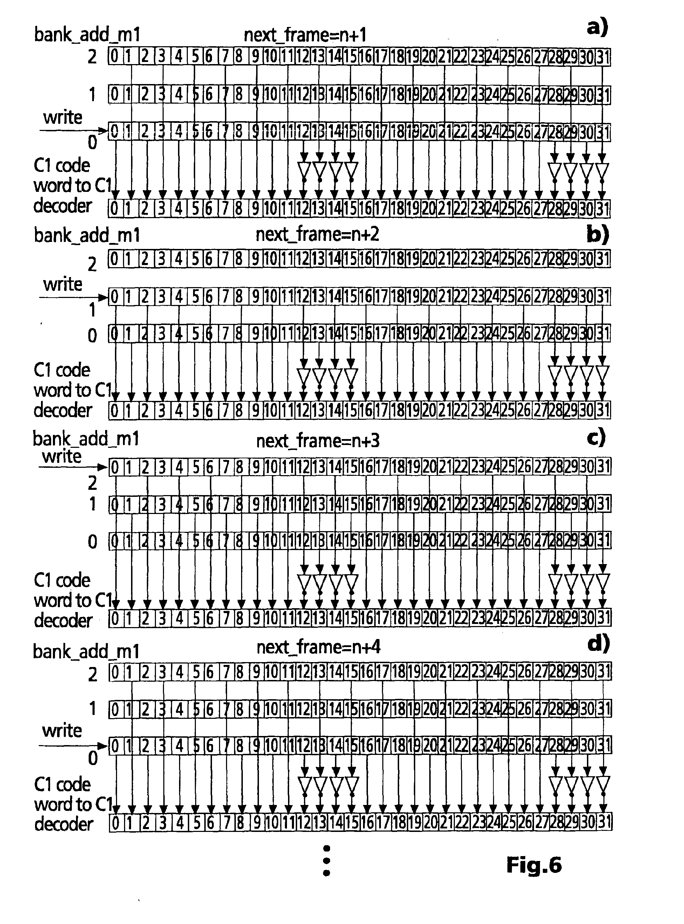

Fig. 6 illustrates the data flow in the M1 memory. The M1 memory has a circular nature. The data flow in the M1 memory is repeated after 3 next_frame signals, i.e. Fig. 6a and Fig. 6d are identical.

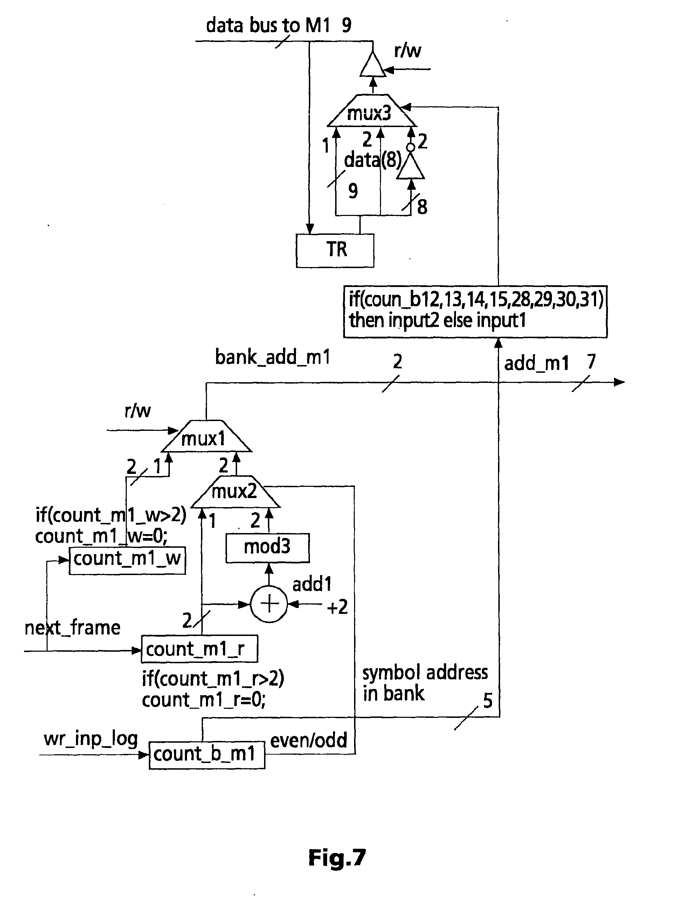

Fig. 7 illustrates the calculation of addresses in the M1 memory. A frame from the input logic is loaded into the corresponding bank of the M1 memory. The bank address is calculated according to the formula:

$$bank\_add\_m1\_w = count\_m1\_w,$$

where count_m1_w counter defines the bank address in the M1 memory during the writing operation.
32 symbols are loaded into the corresponding symbol addresses of a bank. The count_b_m1 counter defines the symbol addresses into a bank. The bank address for the reading the M1 memory depends on the even or odd symbol.

The bank addresses are calculated according to the formulas:

$$bank\_add\_0\_m1\_r = count\_m1\_r, //even$$

$$bank\_add\_1\_m1\_r = (count\_m1\_r + 2) \%3) //odd$$

The bank address defines the count_m1_r counter and mod3 circuit. A symbol from the M1 memory is loaded in the TR temporal register (see Fig. 7). Whether a byte is inverted depends on the counter state of the count_b_m1 counter (if count_b_m1 = 12, 13, 14, 15, 28, 29, 30, 31 then to be inverted). An erasure bit is not inverted.

Delayed symbols are transferred to the syndrome generator of the C1 decoder during the first pass.

*De-interleaver task during first pass of the CIRC decoder*

The M2,a memory is used for the de-interleaving and the assembling of C1 code words in C2 code words and comprises 110 banks. Each bank consists of 32 symbols. Each symbol contains 9 bits. The task of the de-interleaver is de-interleaving C1 code words and the assembling of de-interleaved C1 code words into C2 code words.

The de-interleaver task is performed in the M2,a memory during the fist pass of the CIRC decoder by corresponding addressing of the M2,a memory. The de-interleaver task is performed after C1 decoding, correction and storage of a C1 corrected code word into the M2,a memory. The M2,a memory has the circular nature.

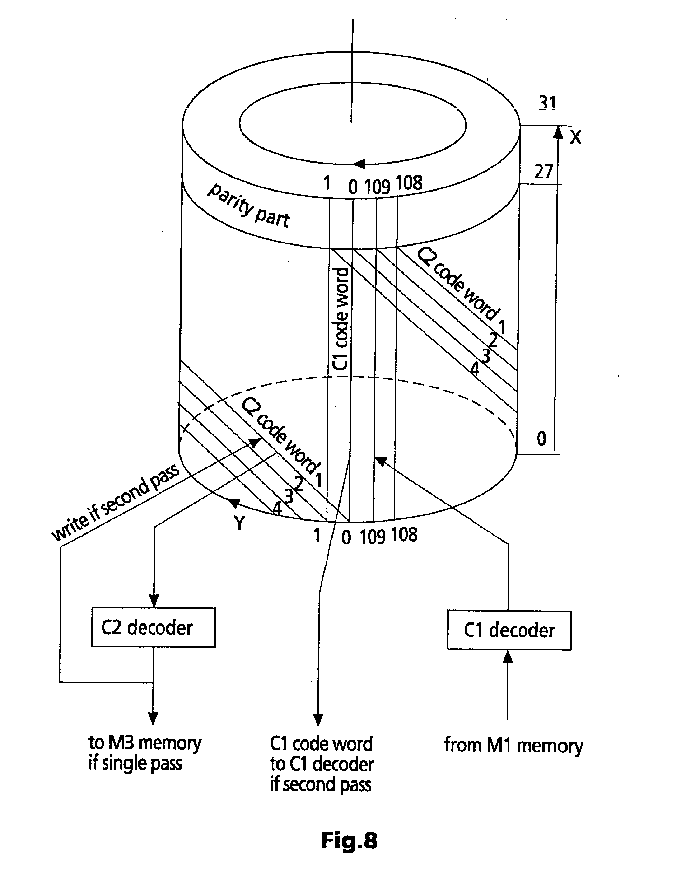

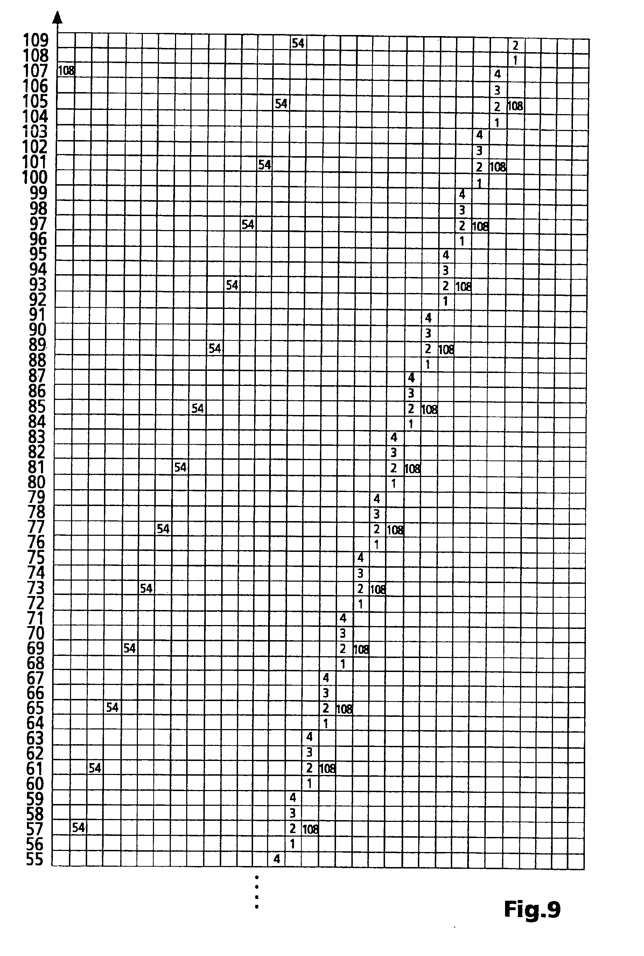

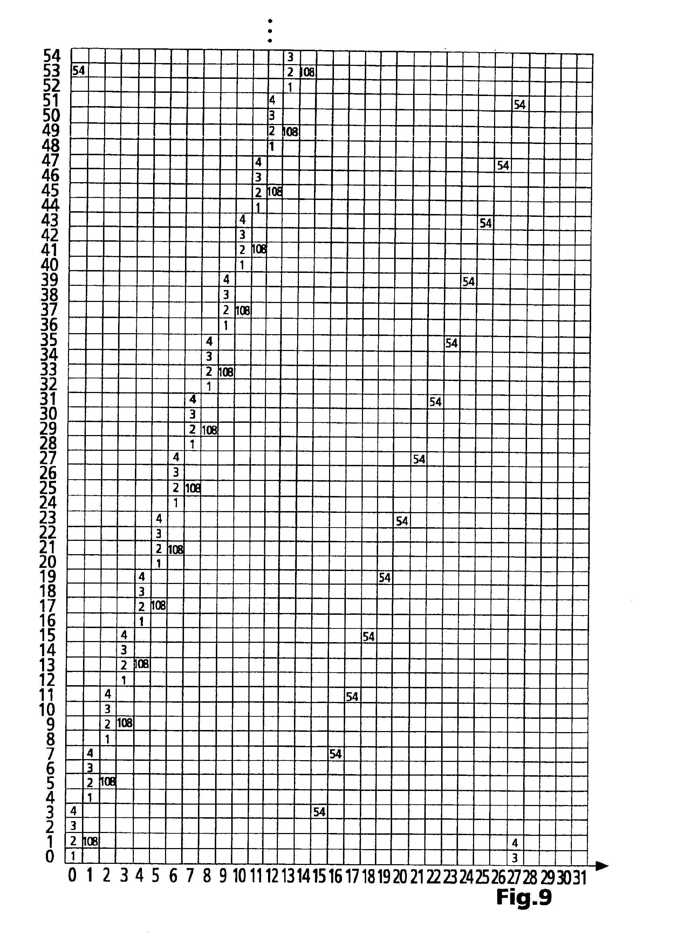

Fig. 8 and 9 illustrate the M2,a memory. For good understanding one can describe the M2,a memory as elements of a two-dimensional Cartesian coordinate system (Fig. 9). The vertical Y axis positions each contain 32 symbols of data (C1 code word). Each horizontal X axis represents a symbol (9 bits) at each Y axis position. Symbols are numbered sequentially within each Y axis position moving from left to right.

The symbols comprising C2 code words are lying along a diagonal line in the M2,a memory space. The symbols of a C2 code word in the 1, 2, 3, 4 , 54 and 108 decoder cycles are shown in Fig. 9. In successive decoding cycles, the symbols comprising a C2 code word are changed. The initially positioned symbol for writing a C2 code word is located at Y position 0 and at X position 0 (Fig. 8).

The general formula for calculating the addresses of symbols in the C2 code word is

$$add\_c2 = (count\_rsd + 4*I)\%mod\ 110,$$

where count_rsd is the counter of decoder cycles (0, ..., 109), which defines the Y position (bank of memory), and where I has values of from 0 to 27.

*De-interleaver task during second pass of the CIRC decoder*

De-interleaver task during the second pass of the CIRC decoder is performed in the M2,b memory. It is a typical de-interleaver having delay lines of unequal length (see Fig. 1). The de-interleaver task is performed after C1 decoding, correction and storage a C1 corrected code word into the buf_reg register.

*Addressing data in M2, a memory during read+write operation*

The C1 and the C2 decoder are operating concurrently on the data in the CIRC decoder. The C1 decoder is operating on the data ahead of the C2 decoder. Output of the C1 decoder (first pass) is initially positioned for writing the C1 code word at Y position 109 (Fig. 8). In each succeeding decoder cycle the output of the C1 decoder is positioned for and writes the corrected C1 code word at the next successively higher valued Y positions (109, 0, 1, ... 0).

Input of the C1 decoder (second pass) is initially positioned for writing the C1 code word at Y position 0 (Fig. 8). In each succeeding decoder cycle the input of the C1 decoder is positioned for and reads the C1 code word at the next successively higher valued Y position (0, 1, 2, ...).

The initially positioned symbol for writing a C2 code word is at Y position 0 and at X position 0 (Fig. 8).

Data processing of the M2,a memory for the double pass of the CIRC decoder (see Fig. 5 and 8) includes the following steps:

1) De-interleaving, read a C2 code word from M2,a to the C2 decoder;
2) Writing the corrected a C1 code word from the C1 decoder into the M2,a memory;
3) Writing the corrected C2 code word from the C2 decoder into the M2,a memory;
4) Read a C1 code from the M2,a memory to the C1 decoder.

Data processing of the M2,a memory for the single pass of the CIRC decoder (see Fig. 5 and 8) includes the following steps:

1) De-interleaving, read a C2 code word from M2,a to the C2 decoder;
2) Writing the corrected C1 code word from the C1 decoder into the M2,a memory.

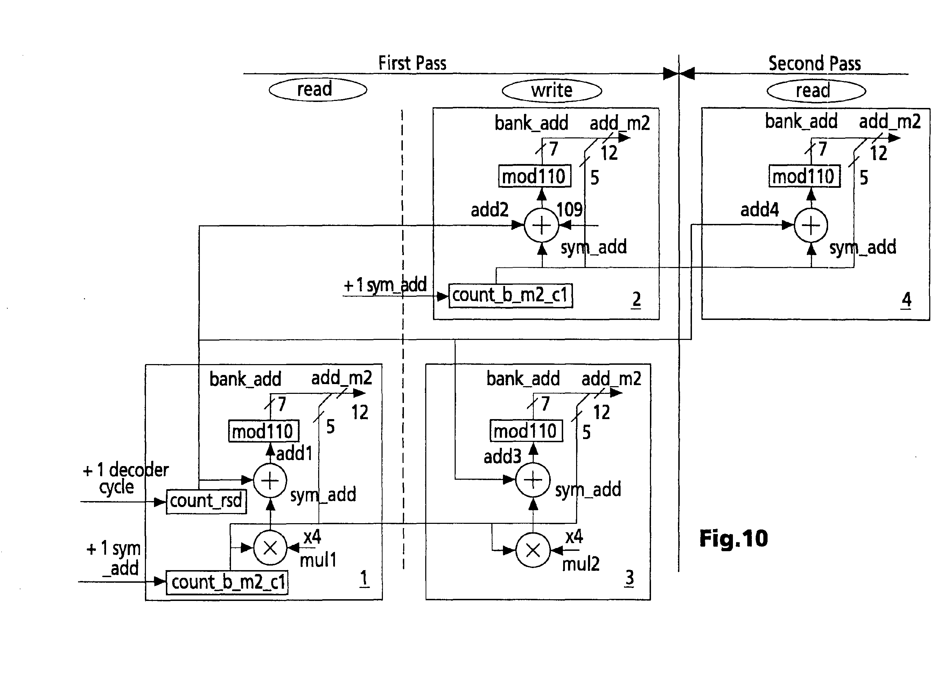

Fig. 10 (address generator) illustrates the calculation of addresses in the M2,a memory (add_m2) during the corresponding steps. The count_rsd counter defines a decoder cycle and is the basic counter to calculate a different bank address of M2,a memory during the write and read operations. The count_b_m2_c1 counter defines a symbol address in a bank (counter counts up to 31). The count_b_m2_c2 counter defines a symbol address in a bank (counter counts up to 27).

With each +1 sym_add the count_b_m2_c1 counter and the count_b_m2_c2 counter are counting up.

The subblock 1 calculates the addresses during the 1st step of double pass of the CIRC decoder.

The formula for calculation of the bank addresses of the M2,a memory is

$$bank\_add = (count\_rsd + 4* count\_b\_m2\_c2)\%mod\ 110,$$

where the count_b_m2_c2 counter defines the address of symbol in a bank.

The symbols are read from the M2,a memory to the C2 decoder according to these addresses. The subblock 2 calculates the addresses during the 2nd step of double pass.

The formula for calculation of the bank addresses of the M2,a memory is

$$bank\_add = (count\_rsd + 109)\%mod\ 110,$$

where the count_b_m2_c1 counter defines the address of symbol in a bank.

Symbols of corrected C1 code word are written from the C1 decoder to the M2,a memory according to these addresses.

The subblock 3 calculates the addresses during the 3rd step of double pass.

The formula for calculation of the bank addresses of the M2,a memory is

$$bank\_add = (count\_rsd + 4* count\_b\_m2\_c2)\ \%mod\ 110,$$

where the count_b_m2_c2 counter defines the address of symbol in a bank. Symbols of corrected C2 code word are written from the C2 decoder to the M2,a memory according to these addresses.

The subblock 4 calculates the addresses during the 4th step of double pass.

The formula for calculation of the bank addresses of the M2,a memory is

$$bank\_add = (count\_rsd + 109)\%mod\ 110,$$

where the count_b_m2_c1 counter defines the address of symbols in a bank.

The symbols are read from the M2,a memory to the C1 decoder according to these addresses.

*De-interleaver task during second pass of the CIRC decoder*

For this task to be used the conventional de-interleaver has delay lines of unequal length, see Fig. 1. This de-interleaver has been implemented in the M2,b memory.

*Two symbol delay task*

The M3 memory is used for the two-symbol delay task in the CIRC decoder and comprises three banks with the addresses 0, 1, 2. The bank0 consist of 28 symbols, the bank1 and the bank2 each consist of 24 symbols. Data after C2 decoding and correction are loaded into bank0.
Two-symbol delay task comprises two steps:

1) Read the delayed data to the output logic;
2) Overwriting the M3 memory.

The following table 1 is used to generate the addresses during the first step:

| count_b | 0 | 1 | 2 | 3 | 4 | 5 | 6 | 7 | 8 | 9 | 10 | 11 |
|---------|---|---|---|---|---|---|---|---|---|---|----|----|
| bank    | 0 | 0 | 0 | 0 | 2 | 2 | 2 | 2 | 0 | 0 | 0  | 0  |
| sym_add | 0 | 1 | 6 | 7 | 4 | 5 | 6 | 7 | 2 | 3 | 8  | 9  |

| count_b | 12 | 13 | 14 | 15 | 16 | 17 | 18 | 19 | 20 | 21 | 22 | 23 |
|---------|----|----|----|----|----|----|----|----|----|----|----|----|
| bank    | 2  | 2  | 2  | 2  | 0  | 0  | 0  | 0  | 2  | 2  | 2  | 2  |
| sym_add | 12 | 13 | 14 | 15 | 4  | 5  | 10 | 11 | 20 | 21 | 22 | 23 |

wherein count_b is a byte counter, bank is the bank address in the M3, and sym_add is the symbol address in a bank.
The following table 2 is used to generate the addresses during the second step (read/write).

| count_b | 0 | 1 | 2 | 3 | 4 | 5 | 6 | 7 | 8 | 9 | 10 | 11 |
|---------|---|---|---|---|---|---|---|---|---|---|----|----|
| bank_r  | 1 | 1 | 1 | 1 | 0 | 0 | 0 | 0 | 1 | 1 | 1  | 1  |
| sym_add | 4 | 5 | 6 | 7 | 16| 17| 22| 23| 12| 13| 14 | 15 |
| bank_w  | 2 | 2 | 2 | 2 | 1 | 1 | 1 | 1 | 2 | 2 | 2  | 2  |
| sym_add | 4 | 5 | 6 | 7 | 4 | 5 | 6 | 7 | 12| 13| 14 | 15 |

| count_b | 12 | 13 | 14 | 15 | 16 | 17 | 18 | 19 | 20 | 21 | 22 | 23 |
|---------|----|----|----|----|----|----|----|----|----|----|----|----|
| bank_r  | 0  | 0  | 0  | 0  | 1  | 1  | 1  | 1  | 0  | 0  | 0  | 0  |
| sym_add | 18 | 19 | 24 | 25 | 20 | 21 | 22 | 23 | 20 | 21 | 26 | 27 |
| bank_w  | 1  | 1  | 1  | 1  | 2  | 2  | 2  | 2  | 1  | 1  | 1  | 1  |
| sym_add | 12 | 13 | 14 | 15 | 20 | 21 | 22 | 23 | 20 | 21 | 22 | 23 |

*Results of the simulation of the CIRC decoder (double pass)*

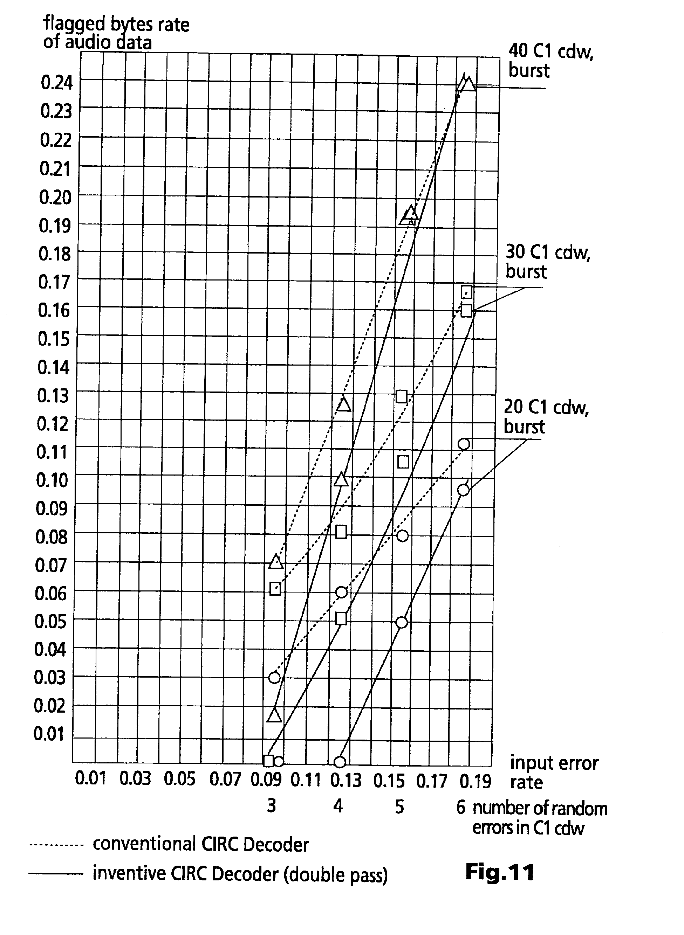

Fig. 11 shows the results of correction of different burst errors. Correction results of a conventional CIRC decoder are depicted by dashed lines, the results for the inventive CIRC decoder are depicted in solid lines.
The following error combinations were input for the correction:

1) Burst error of 20 C1 code words with 3 errors in each code word(random errors) ;
2) Burst error of 20 C1 code words with 4 errors in each code word;
3) Burst error of 20 C1 code words with 5 errors in each code word;
4) Burst error of 20 C1 code words with 6 errors in each code word;
5) Burst error of 30 C1 code words with 3 errors in each code word;
6) Burst error of 30 CI code words with 4 errors in each code word;
7) Burst error of 30 C1 code words with 5 errors in each code word;
8) Burst error of 30 C1 code words with 6 errors in each code word;
9) Burst error of 40 C1 code words with 3 errors in each code word;
10) Burst error of 40 C1 code words with 4 errors in each code word;

11) Burst error of 40 C1 code words with 5 errors in each code word;

12) Burst error of 40 C1 code words with 5 errors in each code word.

Both, the inventive CIRC decoder and a conventional CIRC decoder can correct burst error of 14 completely corrupted C1 code words. It is apparent that, compared with a conventional CIRC decoder, advantageously the inventive CIRC decoder is able to correct burst errors of 20 C1 code words having 3 or 4 errors in each code word.

In case each code word having 5 and 6 errors, the decoder is not able to correct the burst error, but the flagged byte rate of the audio data is still significantly lower than with a conventional CIRC decoder.

Better correcting performance is also obtained with '30 C1 code word' burst error. The inventive CIRC decoder is able to correct burst errors of 30 C1 code words having three errors in each code word, and the flagged byte rate is also lower for higher error numbers per code word.

It is to be noted that separate controlling and addressing of four separate memories increases significantly the speed of the inventive CIRC decoder.

Parallel controlling and addressing of the M1, M2,a memories and the M2,a, M2,b memories during read and write operations also significantly increases the speed of the inventive CIRC decoder.

Memories with smaller sizes are used for de-interleaver implementations as compared with the above-mentioned CIRC decoder.

The de-interleaver task is performed in the M2,a memory during the first pass.

The size of the M2,a memory is 110 x 32 x 9. The de-interleaver task is performed in the M2,b memory during the second pass. The size of the M2,b memory is 1404 x 9 (conventional de-interleaver).

A memory with size 256 x 32 x 9 is used for both de-interleavers in the above-mentioned CIRC decoder.

The two-symbol delay task is performed in the M3 memory. The M3 memory operates as a look up table, which also increases the operational speed of the CIRC decoder.

In the inventive CIRC decoder it is possible to execute the single pass mode of the CIRC decoder.

The present decoding method is suitable to use the so-called erasure correction method of the RS code. Correction of large burst errors of C1 corrupted code words is very effective by low input error rate (each C1 code word comprises at most up to 6 random errors).

**Claims**

1. Method for cross interleave Reed-Solomon code correction comprising the steps of:

   - inputting a first C1 codeword into C1 decoder means from a first memory means;
   - outputting a second C1 codeword into a second memory means from the C1 decoder means;
   - de-interleaving the second C1 codeword to produce a first C2 codeword in the second memory means.

2. Method according to claim 1, wherein the second C1 codeword being the corrected first C1 codeword, in case the first C1 codeword is correctable and the second C1 codeword being a copy of the first C1 codeword in case the first C1 codeword is not correctable.

3. Method according to claim 2, wherein an erasure flag is set for each symbol in the second C1 codeword in case the first C1 codeword is not correctable.

4. Method according to one of claims 1 to 3, further comprising the steps of:

   - inputting the first C2 codeword into C2 decoder means from the second memory means;
   - outputting of a second C2 codeword into the second memory means from the C2 decoder means.

5. Method according to claim 4, wherein the second C2 codeword is the corrected first C2 codeword in case the first C2 codeword is correctable, and the second C2 codeword being a copy of the first C2 codeword in case the first C2 codeword is not correctable.

6. Method according to claim 5, further comprising setting an erasure flag for each symbol in the second C2 codeword in case the first C2 codeword is not correctable.

7. Method according to one of claims 1 to 6, further comprising:

- inputting the second C1 codeword into the C1 decoder means from the second memory means;
- outputting a third C1 codeword into third memory means from the C1 decoder means;
- de-interleaving the third C1 codeword to produce a third C2 codeword in the third memory means.

8. Method according to claim 7, wherein the third C1 codeword being the corrected second C1 codeword in case the second C1 codeword is correctable, and the third C1 codeword being a copy of the second C1 codeword in case the second C1 codeword being not correctable.

9. Method according to claim 8, further comprising setting an erasure flag for each symbol in the third C1 codeword in case the second C1 codeword is not correctable.

10. Method according to one of claims 7, 8 or 9, further comprising:

- inputting the third C2 codeword into the C2 decoder from the third memory means;
- outputting a fourth C2 codeword into a fourth memory means from the C2 decoder means.

11. Method according to claim 10, wherein the fourth C2 codeword being the corrected third C2 codeword in case the third C2 codeword is correctable, and the fourth C2 codeword being a copy of the third C2 codeword in case the third C2 codeword is not correctable.

12. Method according to claim 11, further comprising setting an erasure flag for each symbol in the fourth C2 codeword in case the third C2 codeword is not correctable.

13. Computer program product comprising program means for performing a method in accordance with one of the claims 1 to 12.

14. Reed-Solomon decoder comprising means for cross interleave Reed-Solomon code correction in accordance with a method of one of the claims 1 to 12.

15. Audio or video device, for example a CD or DVD player or recorder, comprising a Reed-Solomon decoder in accordance with claim 14.

Fig.1

**Fig.2**

EP 1 388 946 A1

EP 1 388 946 A1

```
┌──────────┐      ┌──────────────┐      ┌──────────────┐      ┌──────────────┐
│ M1       │      │              │      │ M2,a         │      │ D1           │
│          │      │              │      │  ┌────────┐  │      │              │
│          │      │              │      │  │ C1 CW  │  │      │              │
│          │      │ C1 Decoder   │◄─────┤  └────────┘  │      │ Deinterleaver│
│          │      │              │      │  ┌────────┐  │      │              │
│          │      │              │      │  │ C2 CW  │  │      │              │
│          │      │              │      │  └────────┘  │      │              │
└──────────┘      └──────────────┘      └──────────────┘      └──────────────┘
```

```
┌──────────────┐      ┌──────────────┐      ┌──────────────┐      ┌──────────────┐
│ D2           │      │ M2,b         │      │              │      │ M3           │
│              │      │  ┌────────┐  │      │              │      │              │
│              │      │  │ C1 CW  │◄─┤      │              │      │  ┌────────┐  │
│ Deinterleaver│◄────►│  └────────┘  │─────►│ C2 Decoder   │─────►│  │ C2 CW  │  │
│              │      │  ┌────────┐  │      │              │      │  └────────┘  │
│              │      │  │ C2 CW  │  │      │              │      │              │
│              │      │  └────────┘  │      │              │      │              │
└──────────────┘      └──────────────┘      └──────────────┘      └──────────────┘
```

**Fig.3**

Fig.4

Start

**1**
//counters reset
count_m1_w=0
count_m1_r=0
count_b_m1=0
count_b_m2=0
count_rsd=0
count_mode=0

**2**
no
Is the
nxt_frame
signal activ_?

yes **3**
write frame into M1
memory from input
logic,perform one
symbol delay task

**4**
read C1 cdw from
M1 to C1 decoder,
start C1 decoder

**5**
deinterleaver task
in M2, a memory,
read C2 cdw from
M2, a to C2 decoder,
start C2 decoder

no **6**
Is C1 process
ready_?

yes **7**
write C1 cdw into
M2, a from C1
decoder

no **8**
Is C2 process
ready_?

yes

single pass

**9**
Is double or single
pass of circ_?

double pass **10**
write C2 cdw
into M2, a from
C2 decoder

**11**
read C1 cdw from M2,
a to C1 decoder,
start C1 decoder

**12**
deinterleaver task
in M2, b memory,
read C2 cdw from M2,
b to C2 decoder,
start C2 decoder

no **13**
Is C1 process
ready_?

**14**
write C1 cdw
into buf_reg
from C1 decoder

no **15**
Is C2 process
ready_?

yes

**16**
write C2 cdw into M3
memory , perform two
symbols delay task in
M3 memory, load a data
into output logic

**17**
to generate the signal
rsd process is done

**18**
to update the counters:
count_m1_w=count_m1_w+1;
if(coun_m1_w>2)count_m1_w=0;
count_m1_r=count_m1_r+1;
if(count_m1_r>2)count_m1_r=0;
count_rsd=count_rsd+1;
if(count_rsd)>109count_rsd=0;

**Fig.5**

Fig.6

data bus to M1  9

r/w

mux3

1    2    2

data(8)

9    8

TR

if(coun_b12,13,14,15,28,29,30,31)
then input2 else input1

bank_add_m1          2          add_m1  7

r/w

mux1

2  1        2

mux2

if(count_m1_w>2)    1    2
count_m1_w=0;

count_m1_w    mod3

add1

+    +2

next_frame    2

count_m1_r

if(count_m1_r>2)
count_m1_r=0;

symbol address
in bank            5

wr_inp_log        even/odd

count_b_m1

**Fig.7**

31

X

27

parity part

1   0 109 108

C2 code word 1
2
3
4

C1 code word

0

C2 code word 1
2
3
4

write if second pass

Y

1  0 109 108

C2 decoder

C1 decoder

to M3 memory
if single pass

C1 code word
to C1 decoder
if second pass

from M1 memory

**Fig.8**

**Fig.9**

Fig.9

Fig.10

Fig.11

**European Patent Office**

## EUROPEAN SEARCH REPORT

Application Number

EP 03 29 1868

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,X | US 4 637 021 A (SHENTON DAVID N) 13 January 1987 (1987-01-13) * column 3, line 40 - line 47 * * column 5, line 37 - line 40 * ----- | 1-15 | H03M13/00 G11B20/18 |
| D,A | US 4 546 474 A (SAKO YOICHIRO ET AL) 8 October 1985 (1985-10-08) * abstract; figure 3 * ----- | 1-15 | |
| D,A | US 4 476 562 A (ODAKA KENTARO ET AL) 9 October 1984 (1984-10-09) * abstract; figure 4 * ----- | | |
| D,A | US 4 497 058 A (SAKO YOICHIRO ET AL) 29 January 1985 (1985-01-29) * abstract; figure 3 * ----- | 1-15 | |
| D,A | EP 0 278 383 A (SONY CORP) 17 August 1988 (1988-08-17) * page 1 * ----- | 1-15 | TECHNICAL FIELDS SEARCHED (Int.Cl.7) H03M G11B |

The present search report has been drawn up for all claims

| Place of search | Date of completion of the search | Examiner |
|---|---|---|
| The Hague | 19 September 2003 | Van Staveren, M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 03 29 1868

This annex lists the patent family members relating to the patent documents cited in the above-mentioned European search report.
The members are as contained in the European Patent Office EDP file on
The European Patent Office is in no way liable for these particulars which are merely given for the purpose of information.

19-09-2003

| Patent document cited in search report | | Publication date | Patent family member(s) | | Publication date |
|---|---|---|---|---|---|
| US 4637021 | A | 13-01-1987 | NONE | | |
| US 4546474 | A | 08-10-1985 | JP | 1692245 C | 27-08-1992 |
| | | | JP | 3053816 B | 16-08-1991 |
| | | | JP | 57010557 A | 20-01-1982 |
| | | | JP | 1872456 C | 26-09-1994 |
| | | | JP | 3061380 B | 19-09-1991 |
| | | | JP | 57010560 A | 20-01-1982 |
| | | | JP | 1872457 C | 26-09-1994 |
| | | | JP | 3061381 B | 19-09-1991 |
| | | | JP | 57010561 A | 20-01-1982 |
| | | | AT | 379460 B | 10-01-1986 |
| | | | AT | 275181 A | 15-05-1985 |
| | | | AU | 542428 B2 | 21-02-1985 |
| | | | AU | 7201981 A | 24-12-1981 |
| | | | BE | 889323 A1 | 16-10-1981 |
| | | | BR | 8103911 A | 09-03-1982 |
| | | | CA | 1161565 A1 | 31-01-1984 |
| | | | CA | 1201811 B | 11-03-1986 |
| | | | CH | 653504 A5 | 31-12-1985 |
| | | | DE | 3124425 A1 | 24-06-1982 |
| | | | DK | 270581 A ,B, | 21-12-1981 |
| | | | ES | 8203542 A1 | 01-07-1982 |
| | | | FR | 2485299 A1 | 24-12-1981 |
| | | | GB | 2079994 A ,B | 27-01-1982 |
| | | | IT | 1194807 B | 28-09-1988 |
| | | | NL | 8103001 A ,B, | 18-01-1982 |
| | | | SE | 451928 B | 02-11-1987 |
| | | | SE | 8103836 A | 21-12-1981 |
| US 4476562 | A | 09-10-1984 | JP | 1692246 C | 27-08-1992 |
| | | | JP | 3053818 B | 16-08-1991 |
| | | | JP | 57024143 A | 08-02-1982 |
| | | | JP | 1497090 C | 16-05-1989 |
| | | | JP | 57025047 A | 09-02-1982 |
| | | | JP | 62046893 B | 05-10-1987 |
| | | | AT | 393926 B | 10-01-1992 |
| | | | AT | 314981 A | 15-06-1991 |
| | | | AU | 541864 B2 | 24-01-1985 |
| | | | AU | 7310681 A | 21-01-1982 |
| | | | BE | 889658 A1 | 16-11-1981 |
| | | | BR | 8104615 A | 06-04-1982 |
| | | | CA | 1170776 A1 | 10-07-1984 |
| | | | CH | 653457 A5 | 31-12-1985 |
| | | | DD | 201957 A5 | 17-08-1983 |
| | | | DE | 3128599 A1 | 09-06-1982 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.
EP 03 29 1868

This annex lists the patent family members relating to the patent documents cited in  the above-mentioned European search report.
The members are as contained in the European Patent Office EDP file on
The European Patent Office is in no way liable for these particulars which are merely given for the purpose of information.

19-09-2003

| Patent document cited in search report | | Publication date | Patent family member(s) | | Publication date |
|---|---|---|---|---|---|
| US 4476562 | A | | DK 321481 A ,B, | | 19-01-1982 |
| | | | ES 8205089 A1 | | 01-09-1982 |
| | | | FR 2491278 A1 | | 02-04-1982 |
| | | | GB 2081479 A ,B | | 17-02-1982 |
| | | | IT 1138096 B | | 10-09-1986 |
| | | | KR 8600500 B1 | | 01-05-1986 |
| | | | NL 8103426 A ,B, | | 16-02-1982 |
| | | | NL 9400376 A | | 01-07-1994 |
| | | | SE 462607 B | | 23-07-1990 |
| | | | SE 8104418 A | | 19-01-1982 |
| | | | SE 461620 B | | 05-03-1990 |
| US 4497058 | A | 29-01-1985 | JP 1696306 C | | 28-09-1992 |
| | | | JP 3053817 B | | 16-08-1991 |
| | | | JP 57010558 A | | 20-01-1982 |
| | | | AT 378070 B | | 10-06-1985 |
| | | | AT 275081 A | | 15-10-1984 |
| | | | AU 542192 B2 | | 14-02-1985 |
| | | | AU 7200081 A | | 24-12-1981 |
| | | | BE 889322 A1 | | 16-10-1981 |
| | | | BR 8103912 A | | 09-03-1982 |
| | | | CA 1169154 A1 | | 12-06-1984 |
| | | | CH 653503 A5 | | 31-12-1985 |
| | | | DD 159830 A5 | | 06-04-1983 |
| | | | DE 3123978 A1 | | 01-04-1982 |
| | | | DK 270481 A ,B, | | 21-12-1981 |
| | | | ES 8203543 A1 | | 01-07-1982 |
| | | | FR 2485303 A1 | | 24-12-1981 |
| | | | GB 2079993 A ,B | | 27-01-1982 |
| | | | IT 1194806 B | | 28-09-1988 |
| | | | NL 8103002 A ,B, | | 18-01-1982 |
| | | | SE 451421 B | | 05-10-1987 |
| | | | SE 8103835 A | | 21-12-1981 |
| | | | US 4437185 A | | 13-03-1984 |
| EP 0278383 | A | 17-08-1988 | JP 63193723 A | | 11-08-1988 |
| | | | AT 131975 T | | 15-01-1996 |
| | | | AU 603641 B2 | | 22-11-1990 |
| | | | AU 1134188 A | | 11-08-1988 |
| | | | CA 1295744 C | | 11-02-1992 |
| | | | DE 3854791 D1 | | 01-02-1996 |
| | | | DE 3854791 T2 | | 02-05-1996 |
| | | | EP 0278383 A2 | | 17-08-1988 |
| | | | KR 9512983 B1 | | 24-10-1995 |
| | | | US 4852099 A | | 25-07-1989 |

For more details about this annex : see Official Journal of the European Patent Office, No. 12/82